# EUROPÄISCHE PATENTANMELDUNG

(11) **EP 0 638 815 A2**
(43) Veröffentlichungstag der Anmeldung: **15.02.1995**
(21) Anmeldenummer: 94111847.3
(22) Anmeldetag: 29.07.1994
(51) Int. Cl.: G01R 33/56, G01R 33/561

(54) **Verfahren der bildgebenden Kernspintomographie zur Erzeugung von RARE-Bildern mit zusätzlicher Präparation der Magnetisierung zur Magnetisierung**

(30) Priorität: 11.08.1993 DE 4326902
(71) Anmelder: Hennig, Jürgen, Prof. Dr., D-79100 Freiburg im Breisgau (DE)
(72) Erfinder: Hennig, Jürgen, Prof. Dr., D-79100 Freiburg im Breisgau (DE)
(74) Vertreter: KOHLER SCHMID + PARTNER

(57) **Zusammenfassung**

Bei einem modifizierten RARE-Verfahren wird zwischen dem Anregungsimpuls und dem ersten Refokussierungsimpuls des Multiechozuges eine Evolutionsphase der Zeitdauer tₑ so eingefügt, daß der zeitliche Abstand zwischen dem Anregungsimpuls und dem ersten Refokussierungsimpuls größer oder kleiner als die Zeitdauert τ zwischen dem ersten Refokussierungsimpuls des Multiechozuges und dem ersten Spinecho ist. Dadurch wird die Magnetisierung der angeregten Kerne und die Intensität und/oder die Phase der erzeugten Kernspinsignale in einer Weise beeinflußt, daß auch Effekte von lokalen Feldinhomogenitäten, Diffusionen, Fluß und Bewegungsempfindlichkeiten sichtbar gemacht werden können, die bei Anwendung des herkömmlichen RARE-Verfahrens unterdrückt werden.

## Beschreibung

Die Erfindung betrifft ein Verfahren zum Messen der Kernspinresonanz in ausgewählten Bereichen eines Körpers zum Zwecke der Bilddarstellung von Körperquerschnitten, bei dem der Körper außer einem homogenen Magnetfeld einem Selektionsgradienten ausgesetzt und mit einem selektiven Anregungsimpuls angeregt, danach der Selektionsgradient durch zeitlich begrenzte, zu ihm und untereinander senkrecht stehende Phasenkodierungs- und Lesegradienten ersetzt und der Körper mit einer Folge von Refokussierungsimpulsen bestrahlt wird, wodurch für jede Anregung mehrere Kernspinresonanzsignale in Form sogenannter Spinechos erzeugt werden, bei dem die Einschaltdauer und Stärke der Gradienten auf die Impulsfolge derart abgestimmt sind, daß zum Zeitpunkt jedes Refokussierungsimpulses bezüglich der Wirkung der Gradienten der gleiche Phasenzustand der Kernspins herrscht wie zum Zeitpunkt des vorhergehenden Refokussierungsimpulses, wobei der Lesegradient während des Auftretens des Spinechos in seiner Wirkung symmetrisch zu diesen eingeschaltet ist und der Phasenkodierungsgradient jeweils im Anschluß an einen Refokussierungsimpuls eingeschaltet, vor dem Erscheinen des Spinechos wieder beendet, nach dem Auftreten des Spinechos erneut mit umgekehrter Wirkungsrichtung eingeschaltet und vor dem nächsten Refokussierungsimpuls wieder beendet wird, bei dem die Stärke und/oder Dauer des Phasenkodierungsgradienten nach jedem Refokussierungsimpuls geändert wird und bei dem die Spinechos unter Berücksichtigung von Änderungen des Phasenkodierungsgradienten nach einem zweidimensionalen Fouriertransformationsverfahren rechnerisch zu Bildsignalen verarbeitet werden.

Dieses sogenannte RARE-Verfahren ist bekannt aus der DE 34 34 161 C2.

Das RARE-Verfahren ist ein Schnellbildverfahren, bei welchem nach einem Anregungsimpuls durch mehrere Refokusierungsimpulse Spinechos erzeugt werden, welche durch Anwendung geeigneter Magnetfeldgradienten unterschiedlich phasenkodiert sind. Auf diese Weise kann die Zahl unterschiedlicher Phasenkodierschritte deutlich größer sein als die Zahl der Anregungsimpulse. Im Extremfall lassen sich alle zur Bildrekonstruktion notwendigen Phasenkodierschritte nach einer einzigen Anregung durch Erzeugung eines entsprechend langen Echozugs gewinnen. Aufgrund des Verhaltens transversaler Magnetisierung unter einer solchen Folge äquidistanter Refokussierungsimpuulse ist die Sequenz extrem stabil gegenüber Fluß, Bewegung, Diffusion und Magnetfeldinhomogenitäten, wie sie in biologischen Geweben etwa durch Suszeptibilitätsänderungen verursacht werden.

Eine Reihe von Anwendungen in der bildgebenden Kernspintomographie hat zum Zweck, gerade diese erwähnten Effekte zu messen oder bildhaft darzustellen. Aufgabe der vorliegenden Erfindung ist es daher, die Sequenz des bekannten RARE-Verfahrens so zu modifizieren, daß RARE für solche Effekte unter Beibehaltung der sonstigen günstigen Eigenschaften, der Möglichkeit schneller Bildgebung und der hohen Stabilität des Carr-Purcell-Meyboom-Gill-Echozugs empfindlich wird.

Erfindungsgemäß wird diese Aufgabe dadurch gelöst, daß zwischen dem Anregungsimpuls und dem ersten Refokussierungsimpuls des Multiechozuges eine Evolutionsphase der Zeitdauer tₑ so eingefügt wird, daß der zeitliche Abstand zwischen dem Anregungsimpuls und dem ersten Refokussierungsimpuls größer oder kleiner als die Zeitdauer τ zwischen dem ersten Refokussierungsimpuls des Multiechozuges und dem ersten Spinecho ist.

Mit dem erfindungsgemäßen Verfahren wird durch die Einführung der Evolutionsphase die Magnetisierung der betrachteten Kerne derart beeinflußt, daß die Intensität und/oder Phase der nachfolgenden Signale in Abhängigkeit von dieser Evolutionsphase beeinflußt wird. Dadurch können auch die oben erwähnten Effekte wie Fluß, Bewegung, Diffusion und lokale Magnetfeldinhomogenitäten mit der modifizierten RARE-Sequenz aufgrund der Beeinflussung der Signale durch die Evolutionsphase gemessen werden.

Bevorzugt ist eine Ausführungsform des erfindungsgemäßen Verfahrens, bei der sich die Zeitdauer tₑ um 1 msec bis 100 msec, vorzugsweise um etwa 10 msec von der Zeitdauer τ unterscheidet: Als Obergrenze für tₑ kann die T₂-Relaxationszeit angesehen werden, die nicht wesentlich überschritten werden darf, während die Untergrenze für tₑ bei einer zeitlichen Dauer der Evolutionsphase liegt, bei der die zu beobachtenden Effekte sich gerade noch signifikant im Signal bemerkbar machen.

Bei den meisten Anwendungen des erfindungsgemäß modifizierten RARE-Verfahrens beträgt die Zeitdauer τ zwischen 5 msec und 20 msec. Die Zeitdauer der gesamten Impulssequenz ist in der Regel kleiner als 20 sec, aber meist größer als 1 sec.

Bei einer besonders bevorzugten Ausführungsform wird die Zeitdauer tₑ größer als die Zeitdauer τ gewählt. Die Dauer tₑ der Evolutionsphase kann aber auch kürzer als die Zeitdauer τ zwischen den Refokussierungsimpulsen und den Spinechos, des Multiechozuges gewählt werden. In jedem Fall ist die Zeitdauer τ durch die Refokussierungsbedingung der modifizierten RARE-Sequenz bestimmt und muß sich beim erfindungsgemäßen Verfahren von der Dauer des Evolutionsintervalls unterscheiden.

Bevorzugt ist eine Ausführungsform des erfindungsgemäßen Verfahrens, bei der die Refokussierungsimpulse des Multiechozuges so gewählt werden, daß sie einen um einen Winkel β von 180° abweichenden Flipwinkel der Magnetisierung hervorrufen, so daß Spinechos erzeugt werden, die zu gleichen Zeiten auftreten, jedoch eine je nach ihrem Bildungsmechanismus über verschiedene Refokussierungswege unterschiedliche Phase -α oder +α besitzen. Durch destruktive Überlagerung der Signale kann dabei der Dephasierungseffekt in eine Amplitudenmodulation der Signale überführt werden.

Bei einer bevorzugten Variante dieser Ausführungsform werden symmetrisch um jeden zweiten Refokussierungsimpuls des Multiechozuges zusätzliche Magnetfeldgradientenimpulse in Richtung des Lese-, Phasenkodierungs- oder Scheibenselektionsgradienten geschaltet. Damit kann die Bewegungsempfindlichkeit der Signale in der Ebene des zusätzlich geschalteten Gradienten verstärkt werden.

Bevorzugt ist eine Weiterbildung dieser Variante, bei der die Magnetfeldgradientenimpulse so gewählt werden, daß die Signalanteile des Spinechos von jeweils einer der beiden möglichen Signalgruppen mit Dephasierung -α oder +α ausgelöscht werden. Dadurch wird nur eine der beiden möglichen Signalgruppen beobachtet.

Bei einer anderen Weiterbildung der oben genannten Verfahrensvariante werden die Magnetfeldgradientenimpulse so gewählt, daß die Signalanteile der Spinechos von beiden möglichen Signalgruppen mit Dephasierung -α oder +α zeitlich versetzt auftreten. In diesem Fall können die Signalanteile der beiden Signalgruppen jeweils separat zu Bildern entgegengesetzter Dephasierung rekonstruiert werden.

Besonders bevorzugt ist eine Ausführungsform des erfindungsgemäßen Verfahrens, bei dem während der Evolutionsphase weder Hochfrequenz (HF)-Impulse eingestrahlt werden noch Gradienten anliegen oder geschaltet werden. Die Evolutionsphase besteht bei dieser Ausführungsform in einem zusätzlichen Zeitintervall zwischen dem Anregungsimpuls und dem ersten Refokussierungsimpuls, wobei wegen des Unterschieds in der zeitlichen Dauer tₑ der Evolutionsphase von dem Zeitintervall τ zwischen dem nachfolgenden Refokussierungsimpuls und dem ersten Spinecho dieses und alle nachfolgenden Spinechos eine von den unterschiedlichen Zeitintervallen abhängige Dephasierung und/oder Amplitudenmodulation in Abhängigkeit von allen Mechanismen, welche eine zeitabhängige Dephasierung transversaler Magnetisierung bewirken, erfahren. Bei Veränderung der Zeitdauer tₑ des Evolutionsintervalls werden die Gradienteneffekte während der Echobildung refokussiert, nicht jedoch die zeitlich unveränderlichen, statischen Effekte durch Feldinhomogenitäten. Die lokalen Feldinhomogenitäten können daher auf diese Weise sichtbar gemacht werden.

Besonders bevorzugt ist auch eine Ausführungsform des erfindungsgemäßen Verfahrens, bei der in der Evolutionsphase nach einem Zeitintervall der Dauer tₑ₁ nach dem Anregungsimpuls ein zusätzlicher Refokussierungsimpuls eingestrahlt wird, der nach einer Echozeit tₑ₁ ein zusätzliches Spinecho erzeugt, wobei der Zeitpunkt des ersten Refokussierungsimpulses des Multiechozuges so gewählt wird, daß das Zeitintervall zwischen dem zusätzlichen Spinecho und dem ersten Refokussierungsimpuls des Multiechozuges gleich dem Zeitintervall τ zwischen dem ersten Refokussierungsimpuls des Multiechozuges und dem durch diesen hervorgerufenen ersten Spinecho ist, und wobei gilt: tₑ₁ >> τ. Der dem zusätzlichen Spinecho nachfolgende Mulitechozug erfährt dadurch eine zusätzlich T₂-Gewichtung aber auch eine Signalabschwächung infolge von Diffusion in starken lokalen Magnetfeldern. Dadurch können Effekte von lokalen Feldinhomogenitäten unterdrückt werden, während die Empfindlichkeit des erfindungsgemäßen Verfahrens für Bewegungs- und Diffusions-Effekte bestehen bleibt.

Bei einer bevorzugten Variante werden in der Evolutionsphase symmetrisch zum zusätzlichen Refokussierungsimpuls zusätzliche Magnetgradientenimpulse geschaltet, die eine Dephasierung von Spins, welche sich in Richtung der zusätzlichen Gradienten bewegen, bewirken. Damit kann bei Vorliegen von Diffusion eine zusätzliche diffusionsabhängige Signalabschwächung hervorgerufen werden.

Besonders bevorzugt ist auch eine Ausführungsform des erfindungsgemäßen Verfahrens, bei der in der Evolutionsphase nach einem Zeitintervall der Dauer tₑ₂ nach dem Anregungsimpuls ein Paar von durch ein Zeitintervall der Dauer tₘ separierten weiteren Anregungsimpulsen eingestrahlt wird, welche nach einer Zeitdauer tₑ₂ nach dem zweiten Impuls des Paares ein stimuliertes Echo erzeugen, und bei der der Zeitpunkt des ersten Refokussierungsimpulses des Multiechozuges so gewählt wird, daß das Zeitintervall zwischen dem stimulierten Echo und dem ersten Refokussierungsimpuls des Multiechozuges gleich dem Zeitintervall τ zwischen dem ersten Refokussierungsimpuls des Multiechozuges und dem durch diesen hervorgerufenen ersten Spinecho ist. Das stimulierte Echo erfährt entsprechend der Evolution der Magnetisierung während des tₘ Intervalles eine T₁-Variation, wobei auch eine Signalabschwächung bei Diffusion der Magnetisierungen in lokalen Magnetfeldgradienten auftritt.

Bei einer bevorzugten Variante dieser Ausführungsform werden in der Evolutionsphase symmetrisch vor dem ersten Anregungsimpuls des Paares und nach dem zweiten Anregungsimpuls des Paares zusätzliche Magnetfeldgradientenimpulse geschaltet, die eine Dephasierung von Spins, welche sich in Richtung der zusätzlichen Gradienten bewegen, bewirken. Dies führt zu einer weiteren Signalabschwächung bei Diffusion infolge der Dephasierung.

Um die erwähnten Effekte von Feldinhomogenitäten, Bewegungsempfindlichkeiten, Fluß und Diffusion auf einem mit dem erfindungsgemäßen Verfahren aufgenommenen Bild zu erkennen, ist bei einer bevorzugten Ausführungsform vorgesehen, daß in einem zweiten Meßdurchgang ein Schnittbild des betrachteten Objekts mit dem unmodifizierten RARE-Verfahren aufgenommen und die Differenz zu den Signalamplituden aus dem ersten Meßdurchgang gebildet wird. Bei Aufnahmen von im wesentlichen homogenen Gewebe kann aber auch ein einfacher Vergleich der durch das erfindungsgemäße Verfahren sichtbaren Inhomogenitäten auf die genannten Effekte hinweisen, ohne daß eine Differenzmessung erforderlich wird.

Die Erfindung wird im Folgenden anhand der in der Zeichnung dargestellten Ausführungsbeispiele näher beschrieben und erläutert. Die der Beschreibung und der Zeichnung zu entnehmenden Merkmale können bei anderen Ausführungsformen der Erfindung einzeln, für sich oder zu mehreren in beliebigen Kombinationen Anwendung finden.

Es zeigen:
- Fig. 1: ein Zeitdiagramm einer Impulsfolge des erfindungsgemäßen Verfahrens, wobei die Hochfrequenzimpulse bzw. Echosignale mit Rf, der Scheibenselektionsgradient G_{S}, der Lesegradient G_{R} und der Phasenkodiergradient G_{P} bezeichnet sind;
- Fig. 2: ein Phasendiagramm für die zeitliche Entwicklung der Phase Φ eines Spins und der Wirkung der Magnetfeldinhomogenitäten bei Anwendung des erfindungsgemäßen Verfahrens;
- Fig.3: ein Zeitdiagramm einer Variante des erfindungsgemäßen Verfahrens mit zusätzlichen Magnetfeldgradientenimpulsen symmetrisch um jeden zweiten Refokussierungsimpuls, wobei eine der beiden möglichen Signalgruppen ausgelöscht wird;
- Fig. 4: ein Zeitdiagramm einer Variante des erfindungsgemäßen Verfahrens mit zusätzlichen Magnetfeldgradientenimpulsen symmetrisch um jeden zweiten Refokussierungsimpuls, wobei die beiden Signalgruppen zeitlich versetzt erzeugt werden;
- Fig. 5: eine Variante mit einem zusätzlichen Refokussierungsimpuls in der Evolutionsphase;
- Fig. 6: eine Variante mit einem Paar von weiteren 90°-Impulsen in der Evolutionsphase;
- Fig. 7a: eine Variante mit einem zusätzlichen Refokussierungsimpuls in der Evolutionsphase mit zusätzlich angelegten Gradienten im Evolutionsintervall; und
- Fig. 7b: eine Variante mit einem Paar von weiteren 90°-Impulsen in der Evolutionsphase mit zusätzlich angelegten Gradienten im Evolutionsintervall.

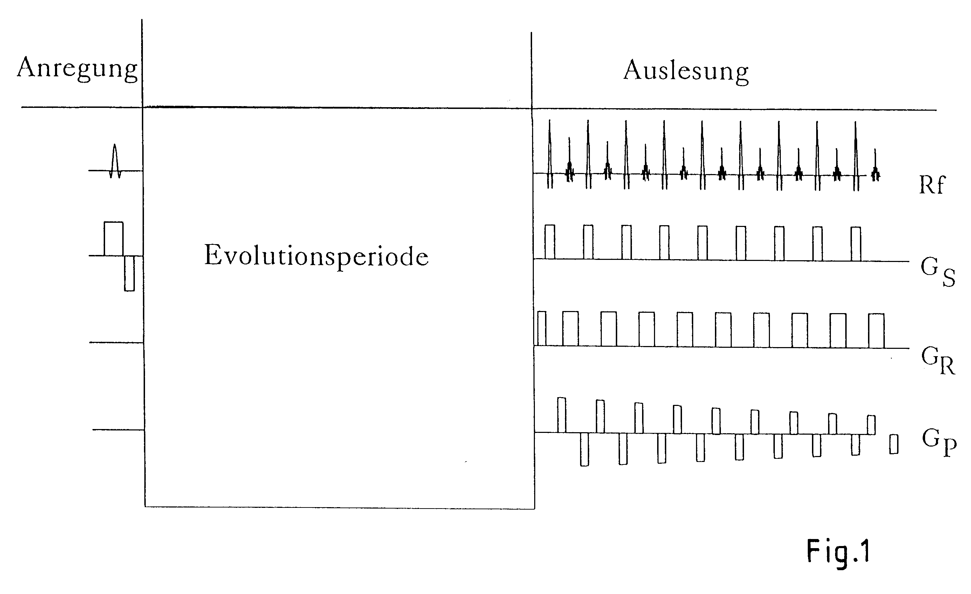

Das erfindungsgemäße Verfahren modifiziert die RARE-Sequenz dergestalt, daß zwischen dem Anregungsimpuls (in der Regel ein 90°-HF-Impuls) und der Erzeugung des CPMG-Echozugs eine Evolutionsphase eingefügt wird, während derer das Spinsystem sich in Abhängigkeit von einem zu beobachtenden Parameter entwickelt. Anschließend wird die so präparierte Magnetisierung mit einem Multiechozug ausgelesen und in der vom RARE-Verfahren bekannten Weise phasenkodiert, so daß nach einem oder mehreren solcher Anregungszyklen die zur Bildrekonstruktion notwendige Information gesammelt werden kann (Fig. 1).

Hier - wie in den folgenden Abbildungen - bezeichnet Rf die Abfolge der Hochfrequenzimpulse und Signale, G_{S} den Scheibenselektionsgradienten, G_{R} den Lesegradienten und G_{P} den Phasenkodiergradienten. Im folgenden werden eine Reihe von Möglichkeiten vorgestellt, wie diese Evolutionsphase gestaltet werden kann, um die gewünschte Empfindlichkeit für verschiedene Parameter zu erreichen.

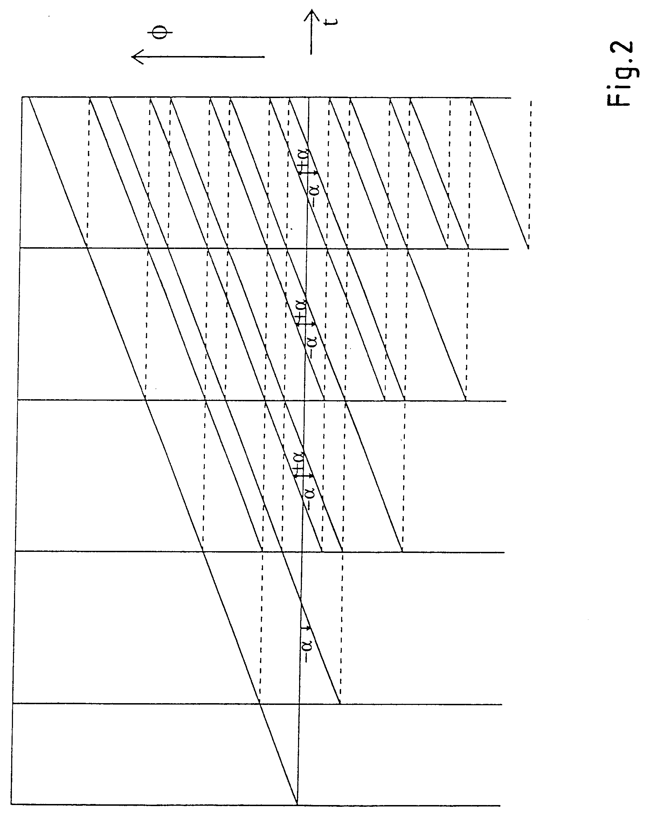

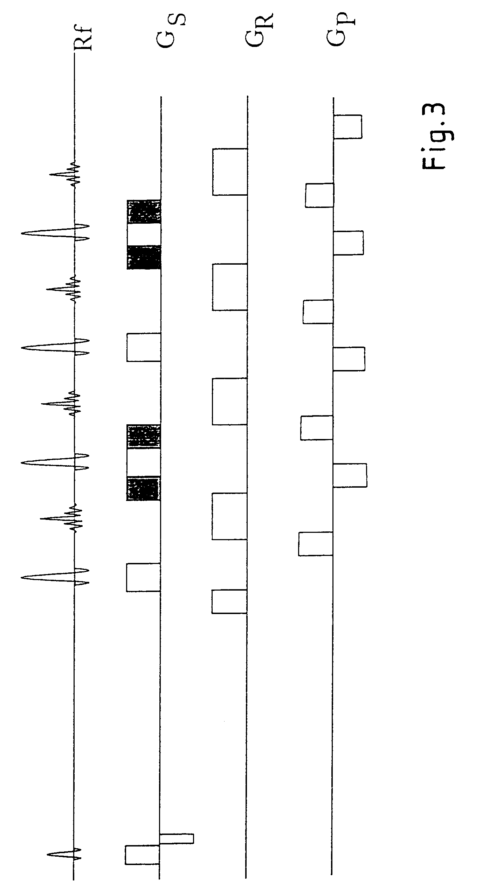

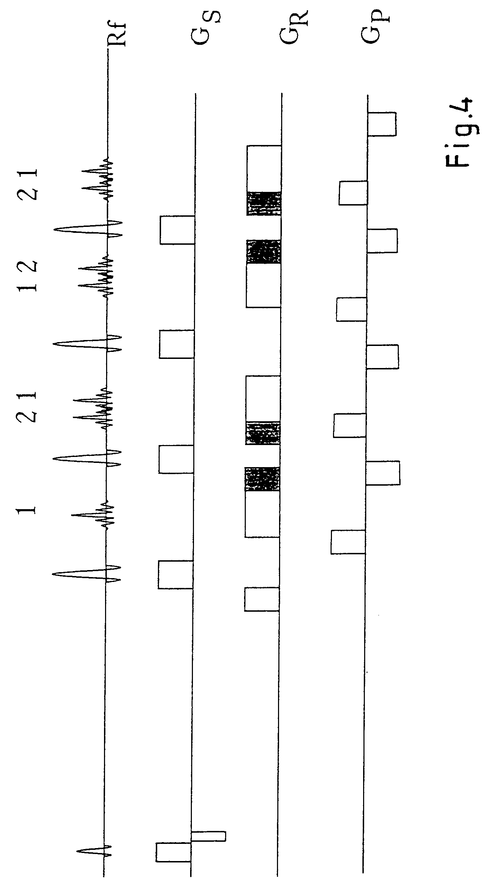

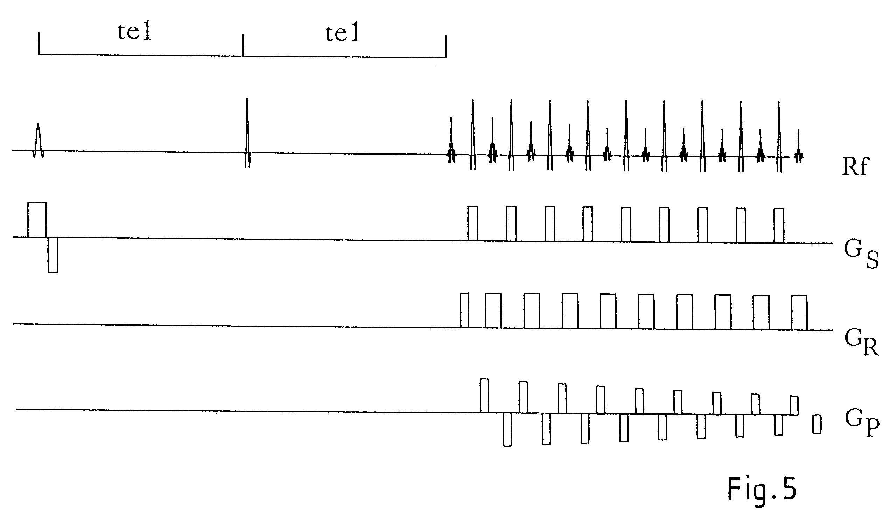

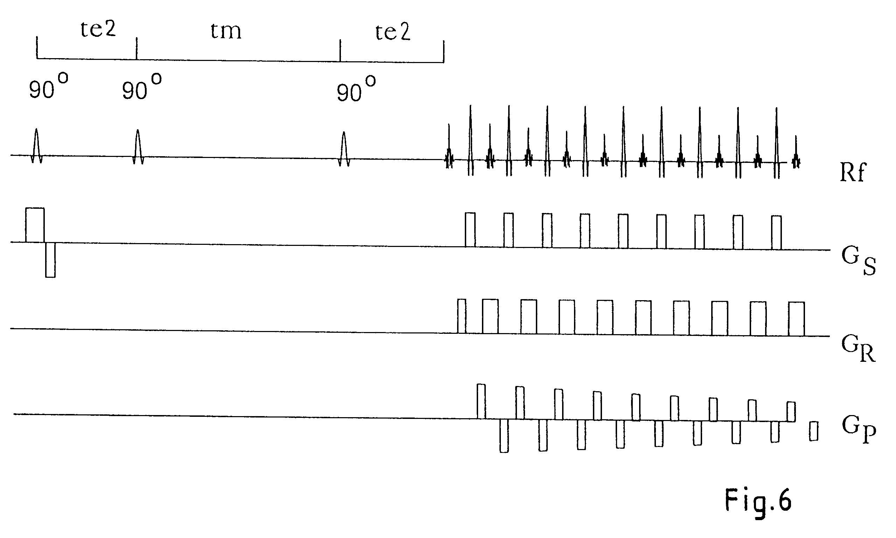

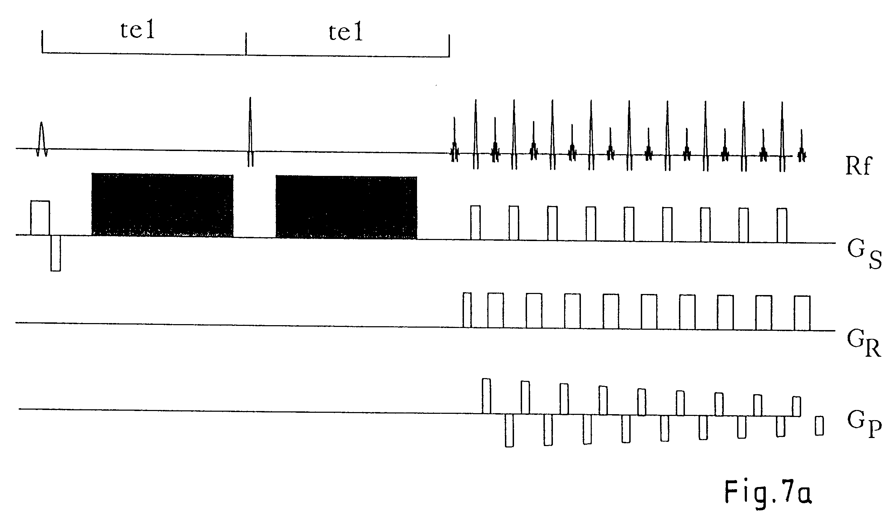

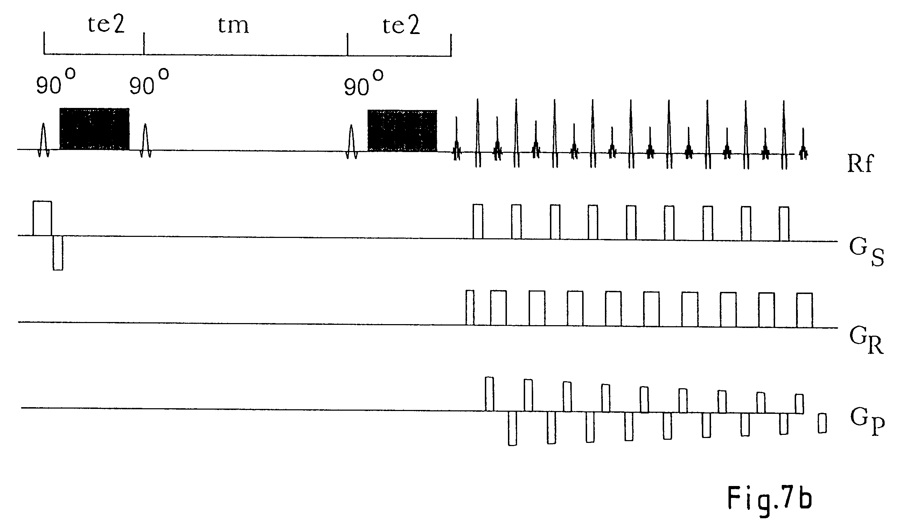

Neben der Verwendung der eigentlichen RARE-Sequenz kann zur Auslesung der Daten auch eine Sequenz verwendet werden, bei welcher innerhalb jeder Spinecho-Refokussierung mehrere Signale durch Gradienteninversion erzeugt werden (GRASE-Verfahren).
1. Suszeptibilitätsempfindliches RARE
   1.1. Statische Suszeptibilität
      Hierbei sind zwei unterschiedliche Suszeptibilitätseffekte separat beobachtbar. Der statische Suszeptibilitätseffekt beruht auf der zeitabhängigen Dephasierung von Spins in lokalen unterschiedlichen Magnetfeldern, der dynamische Suszeptibilitätseffekt entsteht durch Diffusion von Spins in starken lokalen Magnetfeldgradienten.
      Der erste Effekt, welcher in der normalen RARE-Sequenz durch Refokussierung vollständig unterdrückt wird, kann in die RARE-Sequenz eingeführt werden, indem die Evolutionsphase in einem Zeitintervall besteht, während dem sich der beschriebene Effekt entwickelt. Die so präparierte Magnetisierung wird nun durch Multiecho-Bildung ausgelesen.
      Da die Magnefeldgradienten entsprechend der Grundsequenz angewendet werden, ergibt sich bezüglich der gradientenabhängigen Dephasierungen die hohe Stabilität der RARE-Sequenz. So sind die zu einem Echo beitragenden Signalanteile unabhängig vom Refokussierungsweg stets kohärent. Daher wird die Signalkohärenz nicht durch Abweichungen des Refokussierungsflipwinkels vom Idealwert 180° zerstört. Aufgrund der zusätzlichen Präparationsphase besteht diese Kohärenz nicht in bezug auf die Magnetfeldinhomogenität. Dies ist in einem Phasendiagramm in Fig. 2 gezeigt. Das Diagramm gibt die zeitliche Entwicklung der Phase Φ eines Spins unter der Wirkung der Magnetfeldinhomogenitäten an. Die Hochfrequenzimpulse sind dabei durch senkrechte Linien markiert. Die schrägen Linien entsprechen den jeweiligen transversalen Magnetisierungen, die gestrichelten waagrechten Linien kohärenten z-Magnetisierungen, welche im weiteren zur Bildung von stimulierten Echos führen.
      Die Signalbildung erfolgt jeweils in der Mitte zwischen zwei Refokussierungsimpulsen. Bei einem Standard-RARE Verfahren ist diese inhomogenitätsbedingte Phase zur Echozeit gleich Null. Nimmt man bei Veränderung der Evolutionsperiode eine suszeptibilitätsabhängige Dephasierung um einen Betrag α für das erste ausgebildete Echo an, so zeigt sich, daß die folgenden Signale je nach Refokussierungsweg entweder um +α oder um -α dephasiert sind. Die Überlagerung der unterschiedlichen Signalanteile führt dann zu einer inkohärenten Überlagerung und im Extremfall für α = 90° und einer gleichmäßigen Verteilung der Magnetisierung in beide Signalgruppen zur Signalauslöschung.
      Das Verfahren läßt sich durch Anwendung zusätzlicher Gradientenimpulse so variieren, daß die beiden Signalgruppen getrennt auftreten. In der in Fig. 3 gezeigten Weise werden zwischen zwei Refokussierungsimpulsen die beiden Signalgruppen separat erzeugt, indem ein zusätzlicher Gradient in die Refokussierungsintervalle eingeführt wird. Dieser zusätzliche Gradient wird von Echo zu Echo alternierend vor und hinter das auszulesende Signal geschaltet, da andernfalls alternierend je ein Signal mit Dephasierung +α und im nächsten Echo mit Dephasierung -α erzeugt würde.
      In Fig. 3 ist dieser zusätzliche Gradient schattiert in Richtung des Scheibenselektionsgradienten eingefügt. In diesem Fall werden die nicht zu messenden Signalanteile dephasiert und werden damit nicht beobachtet.
      Der zusätzliche Gradient kann auch in einer anderen Richtung angelegt werden. Fig. 4 zeigt die Verwendung in Richtung des Lesegradienten. Bei Verwendung des Lesegradienten lassen sich auch beide Signalgruppen nebeneinander beobachten. Zu beachten ist, daß in dieser Sequenz die Reihenfolge der Zugehörigkeit der Echos zu den beiden Signalgruppen von Echo zu Echo alterniert, was durch die Numerierung der Echos in Fig. 4 aufgezeigt ist.
      Auch eine Selektion durch zusätzliche Gradienten in Richtung des Phasengradienten ist möglich. Hierbei ist jedoch zu beachten, daß der zusätzliche Gradient eine Amplitude aufweisen muß, welche größer ist als die maximale Größe des zur Ortskodierung verwendeten Gradienten, da ansonsten Bildartefakte durch nicht vollständig dephasierte Signalanteile auftreten können.
   1.2. Dynamische Suszeptibilität
      Der dynamische Suszeptibilitätseffekt tritt durch Diffusion frei beweglicher Moleküle in starken Magnetfeldgradienten auf. Ein wesentlicher Unterschied im Vergleich zum statischen Suszeptibilitätseffekt beruht darin, daß der hierdurch bewirkte Kohärenzverlust der transversalen Magnetisierung nicht durch Rephasierung mittels Spinecho Bildung rückgängig gemacht werden kann. Zu seiner Messung eignet sich folglich ein Experiment, in welchem die dem Effekt entsprechende Evolutionsphase ein Refokussierungsintervall erhält.
      Hierzu kann zum einen die Bildung eines normalen Spinechos Anwendung finden (Fig. 5). Die sich so ergebende RARE-Sequenz besteht also aus einem ersten Refokussierungsintervall mit einer langen Echozeit 2 · tₑ₁, wohingegen die Signalerzeugung durch eine schnelle Folge von Spinechos mit im allgemeinen kürzerer Echozeit erfolgt.
      Die Verwendung eines stimulierten Echos durch Einfügen von zwei.90°-Impulsen in der Evolutionsperiode ist zur Sensitivierung für dynamische Suszeptibilität ebenfalls geeignet (Fig. 6). Dies ist insbesonders dann der Fall, wenn sehr lange Präparationszeiten zur Messung kleiner Effekte verwendet werden sollen, da der langsamere Signalzerfall während des tₘ-Intervalls mit der longitudinalen Relaxationszeit T₁ den inhärenten Signalverlust um 50 % gegenüber dem Spinecho aufgrund der Tatsache kompensiert, daß dieses mit der in biologischen Geweben häufig drastisch kürzeren Relaxationszeit T₂ zerfällt.
2. Bewegungs- und Diffusionsmessungen
   Die makroskopische Bewegung sowie die Diffusion von Spins auch in homogenen Feldern läßt sich mit den unter 1.2. beschriebenen Methoden dann messen, wenn in der Evolutionsphase zusätzliche Magnetfeldgradienten eingeführt werden. Die entsprechenden Sequenzen sind in Fig. 7a und 7b gezeigt, wobei die im Vergleich zu den im vorigen Kapitel beschriebenen Sequenzen hinzugefügten Gradienten schattiert dargestellt sind.
   Die Bewegung der Spins in der Evolutionsphase führt zu einer Phasenänderung der nachher gemessenen Signale, welche entweder direkt gemessen oder durch ein Referenzexperiment mit anderen bewegungskodierenden Gradienten bestimmt werden kann, wobei solche Referenzexperimente bevorzugterweise entweder durch Auslassen oder durch Inversion der bewegungskodierenden Gradienten durchgeführt werden. Im Falle der mikroskopischen Diffusion führt die stochastische Dephasierung der Spins innerhalb eines Voxels zu einer Signalreduktion.
   Durch Variation der Stärke dieser Gradienten in aufeinanderfolgenden Experimenten läßt sich die Diffusionskonstante auch quantitativ exakt bestimmten.
   Bei den sämtlichen unter 1.2. und 2. beschriebenen Methoden ist ergänzend festzustellen, daß die zusätzlichen Diffusionseffekte während der Ausbildung des Multiechozuges klein sind, auch wenn dieser insgesamt länger dauert als das Präparationsintervall, da der Diffusionseffekt bei schneller Refokussierung in einem Multiechozug gering ist.
   Des weiteren ist festzustellen, daß in den in Fig. 5 bis 7 gezeigten Sequenzen bei Anwendung nicht-idealer Impulse zusätzliche Signale während der Ausbildung des Echozugs auftreten können analog zu der in Fig. 2 gezeigten Aufspaltung der Signale in zwei Signalgruppen. Diese lassen sich analog zu der in Fig. 4 und 5 gezeigten Weise durch zusätzliche Gradienten unterdrücken.

## Patentansprüche

1. Verfahren zum Messen der Kernspinresonanz in ausgewählten Bereichen eines Körpers zum Zwecke der Bilddarstellung von Körperquerschnitten, bei dem der Körper außer einem homogenen Magnetfeld einem Selektionsgradienten ausgesetzt und mit einem selektiven Anregungsimpuls angeregt, danach der Selektionsgradient durch zeitlich begrenzte, zu ihm und untereinander senkrecht stehende Phasenkodierungs- und Lesegradienten ersetzt und der Körper mit einer Folge von Refokussierungsimpulsen bestrahlt wird, wodurch für jede Anregung mehrere Kernspinresonanzsignale in Form sogenannter Spinechos erzeugt werden, bei dem die Einschaltdauer und Stärke der Gradienten auf die Impulsfolge derart abgestimmt sind, daß zum Zeitpunkt jedes Refokussierungsimpulses bezüglich der Wirkung der Gradienten der gleiche Phasenzustand der Kernspins herrscht wie zum Zeitpunkt des vorhergehenden Refokussierungsimpulses, wobei der Lesegradient während des Auftretens des Spinechos in seiner Wirkung symmetrisch zu diesen eingeschaltet ist und der Phasenkodierungsgradient jeweils im Anschluß an einen Refokussierungsimpuls eingeschaltet, vor dem Erscheinen des Spinechos wieder beendet, nach dem Auftreten des Spinechos erneut mit umgekehrter Wirkungsrichtung eingeschaltet und vor dem nächsten Refokussierungsimpuls wieder beendet wird, bei dem die Stärke und/oder Dauer des Phasenkodierungsgradienten nach jedem Refokussierungsimpuls geändert wird und bei dem die Spinechos unter Berücksichtigung von Änderungen des Phasenkodierungsgradienten nach einem zweidimensionalen Fouriertransformationsverfahren rechnerisch zu Bildsignalen verarbeitet werden,
dadurch gekennzeichnet,
daß zwischen dem Anregungsimpuls und dem ersten Refokussierungsimpuls des Multiechozuges eine Evolutionsphase der Zeitdauer tₑ so eingefügt wird, daß der zeitliche Abstand zwischen dem Anregungsimpuls und dem ersten Refokussierungsimpuls größer oder kleiner als die Zeitdauert τ zwischen dem ersten Refokussierungsimpuls des Multiechozuges und dem ersten Spinecho ist.

2. Verfahren nach Anspruch 1, dadurch gekennzeichnet, daß sich tₑ um 1 msec bis 100 msec, vorzugsweise um etwa 10 msec von τ unterscheidet.

3. Verfahren nach Anspruch 1 oder 2, dadurch gekennzeichnet, daß tₑ größer als τ gewählt wird.

4. Verfahren nach einem der Ansprüche 1 bis 3, dadurch gekennzeichnet, daß die Refokussierungsimpulse des Multiechozuges so gewählt werden, daß sie einen um einen Winkel β von 180° abweichenden Flipwinkel der Magnetisierung hervorrufen, so daß Spinechos erzeugt werden, die zu gleichen Zeiten auftreten, jedoch eine je nach ihrem Bildungsmechanismus über verschiedene Refokussierungswege unterschiedliche Phase -α oder +α besitzen.

5. Verfahren nach Anspruch 4, dadurch gekennzeichnet, daß symmetrisch um jeden zweiten Refokussierungsimpuls des Multiechozuges zusätzliche Magnetfeldgradientenimpulse in Richtung des Lese-, Phasenkodierungs- oder Scheibenselektionsgradienten geschaltet werden.

6. Verfahren nach Anspruch 5, dadurch gekennzeichnet, daß die Magnetfeldgradientenimpulse so gewählt werden, daß die Signalanteile des Spinechos von jeweils einer der beiden möglichen Signalgruppen mit Dephasierung -α oder +α ausgelöscht werden.

7. Verfahren nach Anspruch 5, dadurch gekennzeichnet, daß die Magnetfeldgradientenimpulse so gewählt werden, daß die Signalanteile der Spinechos von beiden möglichen Signalgruppen mit Dephasierung -α oder +α zeitlich versetzt auftreten.

8. Verfahren nach einem der Ansprüche 1 bis 7, dadurch gekennzeichnet, daß während der Evolutionsphase weder Hochfrequenz (HF)-Impulse eingestrahlt werden noch Gradienten anliegen oder geschaltet werden.

9. Verfahren nach einem der Ansprüche 1 bis 7, dadurch gekennzeichnet, daß in der Evolutionsphase nach einem Zeitintervall der Dauer tₑ₁ nach dem Anregungsimpuls ein zusätzlicher Refokussierungsimpuls eingestrahlt wird, der nach einer Echozeit tₑ₁ ein zusätzliches Spinecho erzeugt, und daß der Zeitpunkt des ersten Refokussierungsimpulses des Multiechozuges so gewählt wird, daß das Zeitintervall zwischen dem zusätzlichen Spinecho und dem ersten Refokussierungsimpuls des Multiechozuges gleich dem Zeitintervall τ zwischen dem ersten Refokussierungsimpuls des Multiechozuges und dem durch diesen hervorgerufenen ersten Spinecho ist, wobei tₑ₁ >> τ.

10. Verfahren nach Anspruch 9, dadurch gekennzeichnet, daß in der Evolutionsphase symmetrisch zum zusätzlichen Refokussierungsimpuls zusätzliche Magnetfeldgradientenimpulse geschaltet werden, die eine Dephasierung von Spins, welche sich in Richtung der zusätzlichen Gradienten bewegen, bewirken.

11. Verfahren nach einem der Ansprüche 1 bis 7, dadurch gekennzeichnet, daß in der Evolutionsphase nach einem Zeitintervall der Dauer tₑ₂ nach dem Anregungsimpuls ein Paar von durch ein Zeitintervall der Dauer tₘ separierten weiteren Anregungsimpulsen eingestrahlt wird, welche nach einer Zeitdauer tₑ₂ nach dem zweiten Impuls des Paares ein stimuliertes Echo erzeugen, und daß der Zeitpunkt des ersten Refokussierungsimpulses des Multiechozuges so gewählt wird, daß das Zeitintervall zwischen dem stimulierten Echo und dem ersten Refokussierungsimpuls des Multiechozuges gleich dem Zeitintervall τ zwischen dem ersten Refokussierungsimpuls des Multiechozuges und dem durch diesen hervorgerufenen ersten Spinecho ist.

12. Verfahren nach Anspruch 11, dadurch gekennzeichnet, daß in der Evolutionsphase symmetrisch vor dem ersten Anregungsimpuls des Paares und nach dem zweiten Anregungsimpuls des Paares zusätzliche Magnetfeldgradientenimpulse geschaltet werden, die eine Dephasierung von Spins, welche sich in Richtung der zusätzlichen Gradienten bewegen, bewirken.

13. Verfahren nach einem der vorhergehenden Ansprüche, dadurch gekennzeichnet, daß in einem zweiten Meßdurchgang ein Schnittbild des betrachteten Objekts mit dem unmodifizierten RARE-Verfahren aufgenommen und die Differenz zu den Signalamplituden aus dem ersten Meßdurchgang gebildet wird.
